# EUROPEAN PATENT SPECIFICATION

(11) **EP 0 521 349 B1**
(45) Date of publication and mention of the grant of the patent: **21.10.1998**
(21) Application number: 92110307.3
(22) Date of filing: 17.06.1992
(51) Int. Cl.: H03M 1/44

(54) **High-speed a/d conversion using a series of one-bit conversion stages**
Hochgeschwindigkeits-AD-Wandler mit einer Reihe von Ein-Bit-Wandlungsstufen
Convertisseur analogique à haute vitesse faisant usage d'une série d'étages de conversion à un bit

(30) Priority: 19.06.1991 JP 174640/91
(43) Date of publication of application: 07.01.1993
(73) Proprietor: NEC CORPORATION, Tokyo (JP)
(72) Inventor: Ichihara, Masaki, c/o NEC Corporation, Minato-ku, Tokyo (JP)
(74) Representative: VOSSIUS & PARTNER

(56) References cited:
- DE-A- 3 015 195

## Description

The present invention relates generally to analog-to-digital converters, and more particularly to an A/D converter comparable in speed to flash A/D converters.

Two approaches are available for analog-to-digital conversion. One is a serial method called successive approximation A/D algorithm in which is basically a tree search through all possible quantization levels, where each conversion step selects the next branch to follow based on the result of the previous estimate. While it requires only one comparator, the A/D conversion process is several times higher than the sampling rate. The second approach is the parallel A/D conversion architecture, which is commonly referred to as flash A/D conversion, and provides the high speed approach to quantizing an analog signal. This architecture relies on a technique where all of the possible quantization levels are simultaneously compared to the analog input signal. To compare all the quantization levels of an N-bit A/D structure, 2^{N} - 1 comparators are required. As a result, shortcomings inherent in the conventional flash A/D converter are that a substantial amount of chip size is required for circuit integration and a substantial amount of energy is dissipated.

It is therefore an object of the present invention to provide a highspeed analog-to-digital converter which requires small chip size and less waste energy. This object is solved with the features of the claims.

According to the present invention, the analog-to-digital converter of this invention comprises a plurality of one-bit analog-to-digital (A/D) conversion stages connected in series to an analog input terminal to which an analog signal is applied. Each of the A/D conversion stages includes a sample-and-hold circuit for sampling an analog signal from a preceding DE-A-30 15 195 discloses an A/D converter of a series of stages each comprising an amplifier with an amplification factor of "2", a comparator comparing the input voltage of the stage with a first reference voltage and generating an output signal with a first value when the input voltage exceeds the first reference voltage, and a subtractor subtracting a second reference voltage which equals the maximum input voltage from the output voltage of the comparator, and wherein the output voltage of the subtractor is the input voltage of the succeeding stage. In order to provide an A/D converter with a high sampling rate of the input signal, the series of conversion stages is separated into several portions wherein each portion comprises a sample-hold-circuit with two signal terminals and a control terminal, wherein the control terminals of succeeding portions are alternately supplied with two clock signals which do not overlap. The output of each comparator is connected to the input of an associated shift register. Each shift register receives a shift clock pulse after the clock signal of the associated sample-hold-circuit, wherein the delay time corresponds to the settling time of all stages of the associated portion. stage and a comparator for comparing the sampled signal with a specified voltage level to produce a logic signal at one of two discrete levels depending on whether the signal received from the preceding stage is higher or lower than the specified level. The signal received from the preceding stage is summed in each stage with a prescribed reference voltage of one of opposite polarities depending on the discrete level of the logic signal to produce an analog output signal. The sample-and-hold circuits of the one-bit A/D conversion stages are successively driven so that the analog output signal is transferred from one conversion stage to the next in a direction away from the input terminal, and the logic signals generated by the one-bit A/D conversion stages are delayed so that they appear simultaneously at a plurality of digital output terminals.

The present invention will be described in further detail with reference to the accompanying drawings, in which:
Fig. 1 is a circuit diagram of a one-bit A/D converter which is used as a basic building block in the present invention to implement an N-bit analog-to-digital converter;
Fig. 2 is a block diagram of the A/D converter of the present invention; and
Fig. 3 is a timing diagram useful for describing the operation of the present invention.

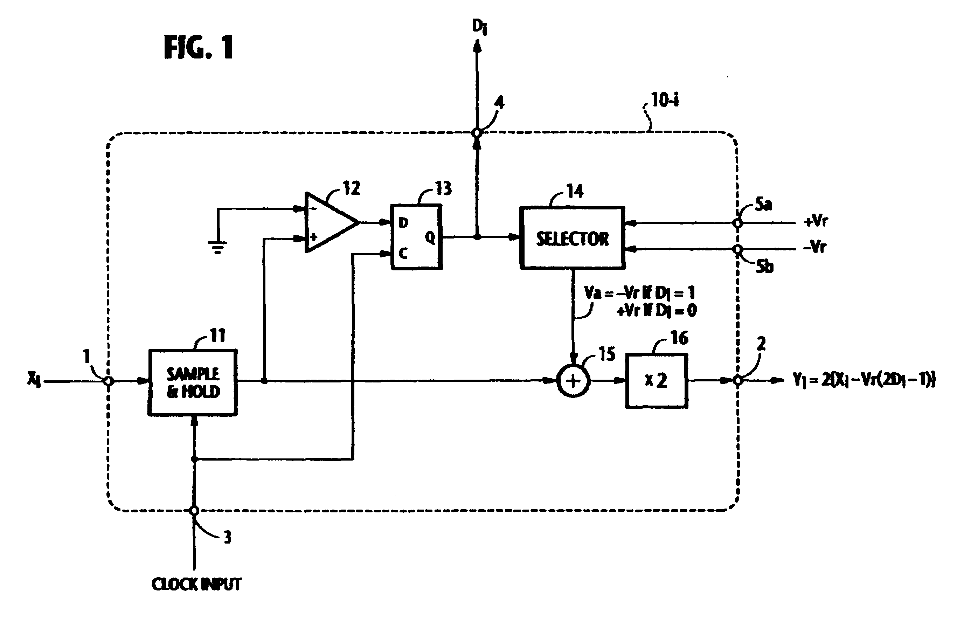

In Fig. 1, there is shown a circuit diagram of a one-bit A/D converter 10-i of the present invention for an N-bit A/D converter (where i indicates the significant bit position of the one-bit A/D converter for the N-bit A/D conversion process). The one-bit A/D converter includes a sample-and-hold circuit 11 for receiving an analog input signal Xᵢ through an input terminal 1 to sample in response to a clock pulse supplied through a clock terminal 3 and hold the sampled value until the next clock pulse. The output of the sample-and-hold circuit 11 is connected to the positive input of a comparator 12 which compares the analog sample value with a zero reference voltage and produces a logic 1 if it is equal to or higher than the reference voltage and a logic 0 otherwise. Thus, the output of comparator 12 is a 1 when the analog input is at zero or positive and a 0 when it is negative. The output of comparator 12 is connected to the data input of a D-type flip-flop 13 which is clocked simultaneously with the sample-and-hold circuit 11. The Q output of flip-flop 13 is delivered through a digital output terminal 4 as a one-bit digital signal Dᵢ and further applied as a control signal to a selector 14 to which reference voltages +Vᵣ and -Vᵣ are supplied through terminals 5a, 5b. When the digital output Dᵢ is one, -Vᵣ is selected and when it is zero, +Vr is selected. The selected reference voltage is applied as Vₐ to an adder 15 where it is arithmetically summed with the output of sample-and-hold circuit 11. A multiply-by-2 circuit 16 is connected to the output of adder 15 to produce an analog output voltage Yᵢ which is equal to 2(Xᵢ + Vₐ).

Since Vₐ is equal to -Vᵣ(2Dᵢ - 1), the following relations hold:${\text{Y}}_{\text{i}} \text{=} {\text{2{X}}_{\text{i}} {\text{- V}}_{\text{r}} {\text{/(2D}}_{\text{i}} \text{- 1)}}$${\text{X}}_{\text{i}} \text{=} {\text{(Y}}_{\text{i}} {\text{/2) + V}}_{\text{r}} {\text{(2D}}_{\text{i}} \text{- 1)}$ Therefore, the A/D converter 10 can be considered to constitute a one-bit A/D converter that produces a logic output Dᵢ depending on the polarity of the analog input voltage Xᵢ.

Since the analog output signal Yᵢ is caused to vary stepwisely by an amount corresponding to the reference voltage Vᵣ in one of opposite senses depending on the digital output Dᵢ, it will be seen that by series-connecting such one-bit A/D converters in N successive stages and having them successively compared the analog outputs of previous stages with zero reference voltage, N digital outputs from such stages will constitute a digital equivalent of the analog input at the first of the N stages, with the first stage producing a sign bit.

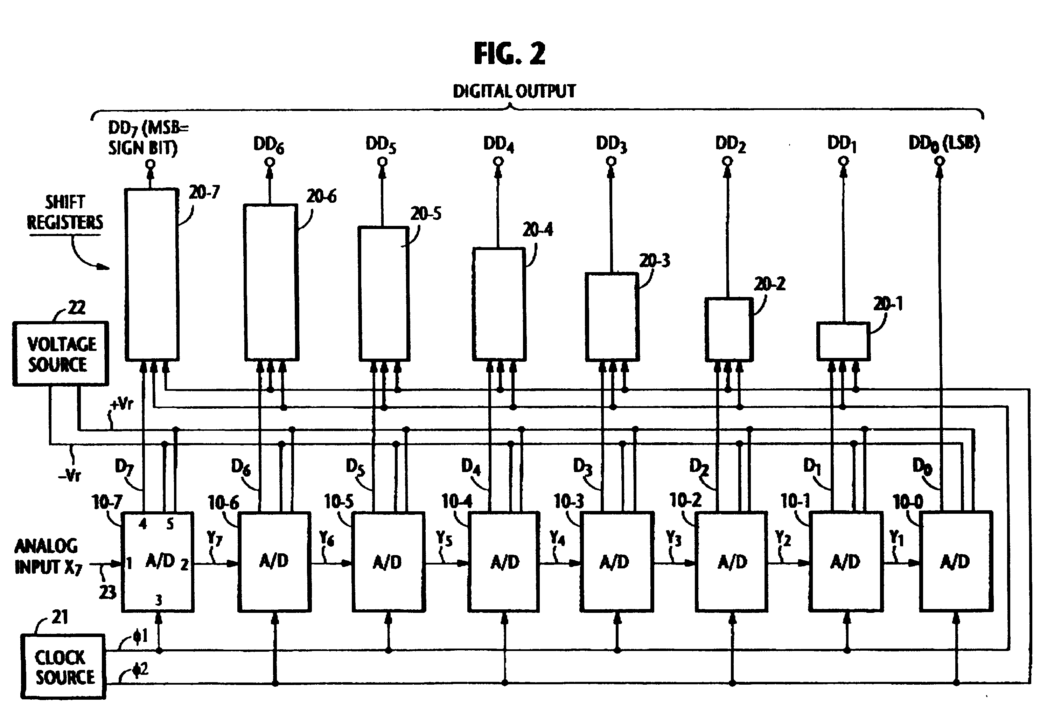

Fig. 2 is a block diagram of an 8-bit A/D converter. One-bit A/D converters 10-0 through 10-7 are connected such that the analog output Yᵢ at terminal 2 of each stage is the analog input Xᵢ₊₁ to the terminal 1 of the next stage and one-bit A/D converter 10-7 is the first stage to produce a sign bit and converter 10-0 is the last stage to produce a least significant bit. Clock source 21 supplies clock pulses with opposite phases φ1 and φ2. Odd-numbered A/D converters 10 are driven by a clock pulse of phase φ1 and even-numbered A/D converters are driven by clock pulse with φ2 so that the analog samples are stepped along successive one-bit converter stages at the clock rate. Voltage source 22 feeds reference voltages +Vᵣ and -Vᵣ to all one-bit A/D converters 10. The digital output D₀ of one n-bit converter stage 10-0 is directly connected to an output terminal DD₀, while the digital outputs Dᵢ of the other stages 10-1 to 10-7 are coupled respectively to shift registers 20-1 through 20-7 having one to seven stages, respectively.

Multiplying Equation (2) with a value 2^{-(N-1-i)} gives the following outputs from successive stages 10-7 - 10-0:${\text{X}}_{\text{7}} \text{=} \frac{{\text{Y}}_{\text{7}}}{\text{2}} \text{+} {\text{V}}_{\text{r}} {\text{(2D}}_{\text{7}} \text{-} \text{1)}$${\text{X}}_{\text{6}} {\text{·2}}^{\text{-1}} \text{=} \frac{{\text{2}}^{\text{-1}} {\text{·Y}}_{\text{6}}}{\text{2}} \text{+} {\text{V}}_{\text{r}} {\text{(2D}}_{\text{6}} \text{-} \text{1)} \text{×} {\text{2}}^{\text{-1}}$${\text{X}}_{\text{5}} {\text{· 2}}^{\text{-2}} \text{=} \frac{{\text{2}}^{\text{-2}} {\text{· Y}}_{\text{5}}}{\text{2}} \text{+} {\text{V}}_{\text{r}} {\text{(2D}}_{\text{5}} \text{- 1)} \text{×} {\text{2}}^{\text{-2}}$${\text{X}}_{\text{4}} {\text{· 2}}^{\text{-3}} \text{=} \frac{{\text{2}}^{\text{-3}} {\text{· Y}}_{\text{4}}}{\text{2}} \text{+} {\text{V}}_{\text{r}} {\text{(2D}}_{\text{4}} \text{- 1)} \text{×} {\text{2}}^{\text{-3}}$${\text{X}}_{\text{3}} {\text{· 2}}^{\text{-4}} \text{=} \frac{{\text{2}}^{\text{-4}} {\text{·Y}}_{\text{3}}}{\text{2}} \text{+} {\text{V}}_{\text{r}} {\text{(2D}}_{\text{3}} \text{- 1)} \text{×} {\text{2}}^{\text{-4}}$${\text{X}}_{\text{2}} {\text{· 2}}^{\text{-5}} \text{=} \frac{{\text{2}}^{\text{-5}} {\text{· Y}}_{\text{2}}}{\text{2}} \text{+} {\text{V}}_{\text{r}} {\text{(2D}}_{\text{2}} \text{- 1)} \text{×} {\text{2}}^{\text{-5}}$${\text{X}}_{\text{1}} {\text{· 2}}^{\text{-6}} \text{=} \frac{{\text{2}}^{\text{-6}} {\text{· Y}}_{\text{1}}}{\text{2}} \text{+} {\text{V}}_{\text{r}} {\text{(2D}}_{\text{1}} \text{- 1)} \text{×} {\text{2}}^{\text{-6}}$${\text{X}}_{\text{0}} {\text{· 2}}^{\text{-7}} \text{=} \frac{{\text{2}}^{\text{-7}} {\text{· Y}}_{\text{0}}}{\text{2}} \text{+} {\text{V}}_{\text{r}} {\text{(2D}}_{\text{0}} \text{- 1)} \text{×} {\text{2}}^{\text{-7}}$

Since the relation Xᵢ = Yᵢ₊₁ holds, the following relation is given: 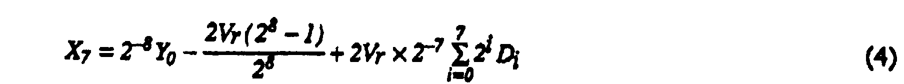 Equation (4) is therefore generalized for an N-bit A/D converter as follows: 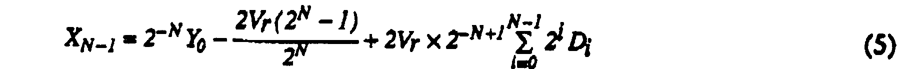 If the analog input Xᵢ of each stage is in the range between -2Vᵣ and +2Vᵣ, Equation (1) can be rewritten as:${\text{Y}}_{\text{i}} \text{=} \text{2} \text{(} {\text{X}}_{\text{i}} {\text{-V}}_{\text{r}} {\text{) if 0 < X}}_{\text{i}} \text{<} {\text{2V}}_{\text{r}}$${\text{Y}}_{\text{i}} \text{=} {\text{2 (X}}_{\text{i}} \text{+} {\text{V}}_{\text{r}} \text{) if 0} \text{>} {\text{X}}_{\text{i}} \text{> -} {\text{2V}}_{\text{r}}$ It is seen that the analog output Yᵢ of each stage also falls in the range between -2Vᵣ and +2Vᵣ.

Therefore, Equation (5) can be rewritten as: 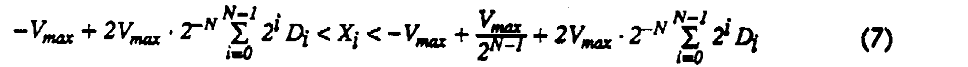 where, Vₘₐₓ is equal to 2Vᵣ and represents the maximum amplitude of the analog input voltage. It is seen from Equation (7) that the N-bit A/D converter divides the range between between -Vₘₐₓ and +Vₘₐₓ into 2^{N} successive voltage intervals and each stage generates a logical 1 output if its analog input corresponds to 2ⁱ-th interval. An analog input voltage varying in the range of values +128 and -128 can be resolved into 2⁸ intervals using a reference voltage Vᵣ equal to a value "64".

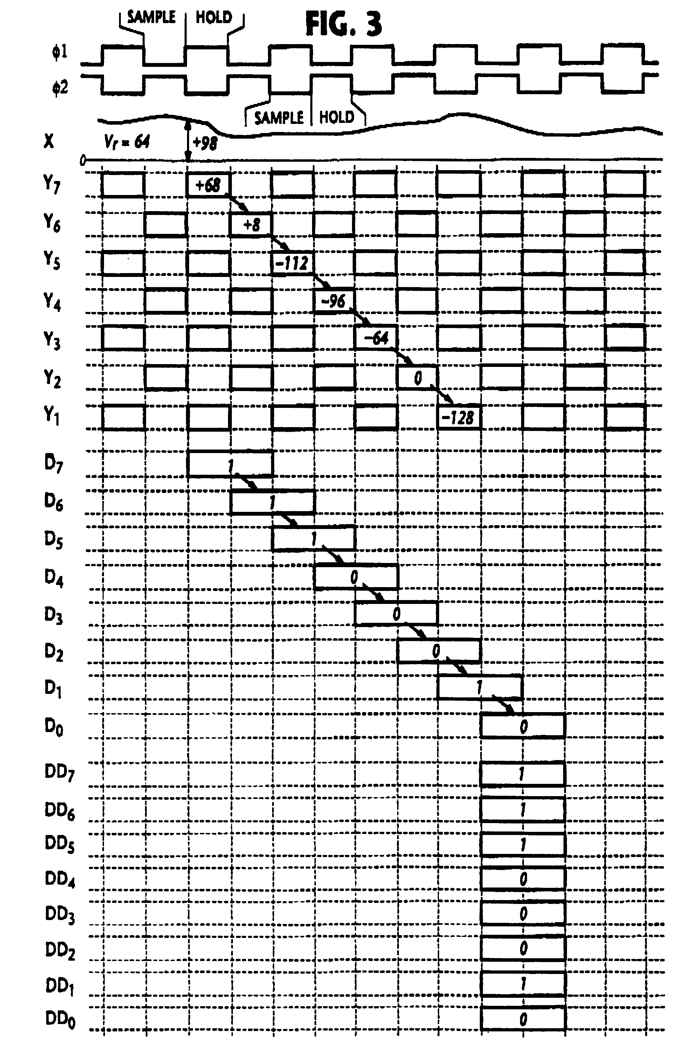

The operation of the N-bit A/D converter will be fully understood with reference to Fig. 3. If the analog input at terminal 23 is of a positive value +98, then the analog output Y_{*7*} from converter stage 10-*7* is given as equal to +68 from Equation (1) and its digital output D_{*7*} is a positive sign bit 1. Using the analog output Y_{*7*} as an analog input, the next stage 10-6 generates a logic 1 as a digital output D₆ and a voltage value +8 as on analog output Y₆. In like manner, subsequent stages 10-5 = 10-0 generate Y₅=-112 (D₅=1), Y₄=-96 (D₄=0), Y₃=-64 (D₃=0), Y₂=0 (D₂=0), Y₁ =-128 (D₁=1), and Y₀=-128 (D₀=0) in succession. Shift registers 20-0 - 20-*7* are clocked by the same clock phases as their corresponding A/D converter stages 10-0 - 10-*7* and are provided with different stages so that the stored digital values "11100010" are made to appear simultaneously at their output terminals DD_{*7*} ∼ DD₀.

Because of the significant reduction of comparators and the associated circuit elements, the present invention assures less circuit complexity with attendant reduction in chip size and power consumption. In addition, since each one-bit converter stage operates at the sampling clock rate, the N-bit A/D converter of the present invention attains substantially the same A/D conversion speed as conventional flash A/D converters.

## Claims

1. An analog-to-digital converter comprising:
a plurality of one-bit analog-to-digital (A/D) conversion stages (10) connected in series to an analog input terminal (23) to which an analog signal (X₇) is applied, each of said A/D conversion stages including sampling means (11) for sampling an analog signal from a preceding stage, a comparator (12) for comparing the sampled signal with a specified voltage level and producing a logic signal at one of two discrete levels depending on whether the signal received from the preceding stage is higher or lower than the specified level, and means (15) for producing an analog output signal which is a sum of the signal received from the preceding stage and a prescribed reference voltage of one of opposite polarities depending on the discrete level of said logic signal;
means (21) for generating a timing signal for successively driving the sampling means (11) of said one-bit A/D conversion stages (10) so that said analog output signal is transferred between successive ones of said A/D conversion stages in a direction away from said input terminal (23); and
means (20) for successively receiving the logic signals from said one-bit A/D conversion stages (10) and delaying the received logic signals so that the delayed logic signals appear simultaneously at a plurality of digital output terminals (DDᵢ).

2. An analog-to-digital converter according to claim 1 comprising:
latch means (13) for latching the logic signal from said comparator (12) in response to said timing signal; and
means (16) for doubling the magnitude of said analog output signal and applying the doubled signal to a succeeding A/D conversion stage.

3. An analog-to-digital converter as claimed in claim 1 or 2, wherein said specified voltage level is zero voltage level and said prescribed reference voltage is equal to one half of a maximum value of said analog input voltage applied to said analog input terminal.

4. A method for translating an analog signal to a digital signal comprising the steps of:
a) sampling an analog signal from an input terminal (23);
b) comparing the signal sampled by the step (a) with a specified voltage level and producing a first logic signal at one of two discrete levels depending on whether the compared signal is higher or lower than the specified level;
c) producing a first analog output signal which is a sum of the sampled signal and a prescribed reference voltage of one of opposite polarities depending on the discrete level of said logic signal;
d) doubling the magnitude of said analog output signal;
e) sampling the analog output signal doubled by the step (d);
f) comparing the signal sampled by the step (e) with said specified voltage level and producing a second logic signal at one of two discrete levels depending on whether the compared signal is higher or lower than the specified level;
g) producing a second analog output signal which is a sum of the signal sampled by the step (e) and the prescribed reference voltage of one of opposite polarities depending on the discrete level of said second logic signal; and
h) delaying the first and second logic signals successively generated by the steps (b) and (f) so that the delayed logic signals appear simultaneously at a plurality of digital output terminals.

## Patentansprüche

1. Analog-Digital-Wandler mit:
mehreren Ein-Bit-Analog-Digital-(A/D)-Wandlungsstufen (10), die zu einem analogen Eingangsanschluß (23) in Reihe geschaltet sind, dem ein analoges Signal (X₇) zugeführt wird, wobei jede der A/D-Wandlungsstufen eine Abtasteinrichtung (11) zum Abtasten eines analogen Signals aus einer vorhergehenden Stufe, einen Komparator (12) zum Vergleichen des abgetasteten Signals mit einem bestimmten Spannungspegel und zum Erzeugen eines logischen Signals auf einem der beiden diskreten Pegel, abhängig davon, ob das aus der vorhergehenden Stufe empfangene Signal höher oder niedriger ist als der bestimmte Pegel, und eine Einrichtung (15) zum Erzeugen eines analogen Ausgangssignals aufweist, das die Summe aus dem aus der vorhergehenden Stufe empfangenen Signal und einer vorgeschriebenen Vergleichsspannung aus entgegengesetzten Polaritäten ist, die von dem diskreten Pegel des logischen Signals abhängen;
einer Einrichtung (21) zum Erzeugen eines Taktsignals, um nacheinander die Abtasteinrichtung (11) der Ein-Bit-A/D-Wandlungsstufen (10) zu betreiben, so daß das analoge Ausgangssignal zwischen aufeinanderfolgenden Stufen der A/D-Wandlungsstufen in einer von dem Eingangsanschluß (23) weg gerichteten Richtung übertragen wird; und
einer Einrichtung (20), um die logischen Signale von den Ein-Bit-A/D-Wandlungsstufen (10) hintereinander zu empfangen und die empfangenen logischen Signale zu verzögern, so daß die verzögerten logischen Signale an mehreren digitalen Ausgangsanschlüssen (DDj) gleichzeitig auftreten.

2. Analog-Digital-Wandler nach Anspruch 1 mit:
einer Speichereinrichtung (13) zum Festhalten des logischen Signals von dem Komparator (12) als Antwort auf das Taktsignal; und
einer Einrichtung (16) zum Verdoppeln der Größe des analogen Ausgangssignals und zum Zuführen des verdoppelten Signals an eine nachfolgende A/D-Wandlungsstufe.

3. Analog-Digital-Wandler nach Anspruch 1 oder 2, wobei der bestimmte Spannungspegel ein Nullspannungspegel ist, und die vorgeschriebene Vergleichsspannung gleich der Hälfte eines Maximalwerts der dem analogen Eingangsanschluß zugeführten analogen Eingangsspannung ist.

4. Verfahren zum Umwandeln eines analogen Signals in ein digitales Signal, das die Schritte aufweist:
a) Abtasten eines analogen Signals von einem Eingangsanschluß (23);
b) Vergleichen des durch Schritt (a) abgetasteten Signals mit einem bestimmten Spannungspegel und Erzeugen eines ersten logischen Signals auf einem der beiden diskreten Pegel, abhängig davon, ob das verglichene Signal höher oder niedriger ist als der bestimmte Pegel;
c) Erzeugen eines ersten analogen Ausgangssignals, das eine Summe des abgetasteten Signals und einer vorgegebenen Bezugsspannung einer der entgegengesetzten Polaritäten abhängig von dem diskreten Pegel des logischen Signals ist;
d) Verdoppeln der Größe des analogen Ausgangssignals;
e) Abtasten des durch den Schritt (d) verdoppelten analogen Ausgangssignals;
f) Vergleichen des durch Schritt (e) abgetasteten Signals mit einem bestimmten Spannungspegel und Erzeugen eines zweiten logischen Signals auf einem der beiden diskreten Pegel, abhängig davon, ob das verglichene Signal höher oder niedriger ist als der bestimmte Pegel;
g) Erzeugen eines zweiten analogen Ausgangssignals, das eine Summe des durch den Schritt (e) abgetasteten Signals und der vorgegebenen Bezugsspannung einer der entgegengesetzten Polaritäten abhängig von dem diskreten Pegel des zweiten logischen Signals ist; und
h) Verzögern des ersten und zweiten logischen Signals, die nacheinander durch die Schritte (b) und (f) erzeugt werden, so daß die verzögerten logischen Signale an mehreren digitalen Ausgangsanschlüssen gleichzeitig auftreten.

## Revendications

1. Convertisseur analogique - numérique comprenant :
une pluralité d'étages (10) de transformation analogique-numérique (A/D) à un bit reliés en série à une borne d'entrée analogique (23) à laquelle un signal analogique X₇ est appliqué, chacun desdits étages de transformation A/D comprenant des moyens d'échantillonnage (11) pour échantillonner un signal analogique en provenance d'un étage précédent, un comparateur (12) pour comparer le signal échantillonné à un niveau de tension spécifié et pour produire un signal logique à l'un de deux niveaux discrets en fonction du fait que le signal reçu en provenance de l'étage précédent est supérieur ou inférieur au niveau spécifié, et des moyens (15) pour produire un signal de sortie analogique qui est une somme du signal reçu en provenance de l'étage précédent et d'une tension de référence prédéterminée de l'une des polarités opposées en fonction du niveau discret dudit signal logique ;
des moyens (21) pour produire un signal de synchronisation pour exciter successivement les moyens d'échantillonnage (11) desdits étages (10) de transformation A/D à un bit de sorte que ledit signal de sortie analogique soit transféré entre des étages particuliers successifs desdits étages de transformation A/D dans un sens s'éloignant de ladite borne d'entrée (23) ; et
des moyens (20) pour recevoir successivement les signaux logiques en provenance desdits étages (10) de transformation A/D à un bit et pour retarder les signaux logiques reçus de sorte que les signaux logiques retardés apparaissent simultanément au niveau d'une pluralité de bornes de sortie numérique (DDᵢ).

2. Convertisseur analogique-numérique selon la revendication 1, comprenant :
des moyens de verrouillage (13) pour verrouiller le signal logique en provenance dudit comparateur (12) en réponse audit signal de synchronisation ; et
des moyens (16) pour doubler l'amplitude dudit signal de sortie analogique et pour appliquer le signal doublé à un étage de transformation A/D suivant.

3. Convertisseur analogique-numérique selon la revendication 1 ou 2, dans lequel ledit niveau de tension spécifié est un niveau de tension nulle et ladite tension de référence prédéterminée est égale à une moitié d'une valeur maximale de ladite tension d'entrée analogique appliquée à ladite borne d'entrée analogique.

4. Procédé pour transformer un signal analogique en signal numérique, comprenant les étapes suivantes :
a) échantillonnage d'un signal analogique en provenance d'une borne d'entrée (23) ;
b) comparaison du signal échantillonné par l'étape (a) à un niveau de tension spécifié et production d'un premier signal logique à l'un des deux niveaux discrets en fonction du fait que le signal comparé est supérieur ou inférieur au niveau spécifié ;
c) production d'un premier signal de sortie analogique qui est une somme du signal échantillonné et d'une tension de référence prédéterminée de l'une de polarités opposées en fonction du niveau discret dudit signal logique ;
d) doublage de l'amplitude dudit signal de sortie analogique ;
e) échantillonnage du signal de sortie analogique doublé par l'étape (d) ;
f) comparaison du signal échantillonné par l'étape (e) audit niveau de tension spécifié et production d'un second signal logique à l'un de deux niveaux discrets en fonction du fait que le signal comparé est supérieur ou inférieur au niveau spécifié ;
g) production d'un second signal de sortie analogique qui est une somme du signal échantillonné par l'étape (e) et de la tension de référence prédéterminée de l'une des polarités opposées en fonction du niveau discret dudit second signal logique ; et
h) retardement des premier et second signaux logiques successivement produits par les étapes (b) et (f) de sorte que les signaux logiques retardés apparaissent en même temps au niveau d'une pluralité de bornes de sortie numérique.
